# EUROPEAN PATENT SPECIFICATION

(11) **EP 1 997 940 B1**
(45) Date of publication and mention of the grant of the patent: **19.08.2015**
(21) Application number: 07738104.4
(22) Date of filing: 02.03.2007
(51) Int. Cl.: C30B 29/06, C30B 15/20

(54) **METHOD FOR MANUFACTURING Si SINGLE CRYSTAL INGOT BY CZ METHOD**
VERFAHREN ZUR HERSTELLUNG EINES SI-EINKRISTALLSTABS NACH DEM CZ-VERFAHREN
PROCEDE DE FABRICATION D'UN LINGOT DE SILICIUM MONOCRISTALLIN PAR TIRAGE DE CRISTAL

(30) Priority: 03.03.2006 JP 2006058469
(43) Date of publication of application: 03.12.2008
(73) Proprietor: Niigata University, Niigata-shi, Niigata 950-2181 (JP); SUMCO Corporation, Tokyo 105-8634 (JP)
(72) Inventor: GOTO, Terutaka, Niigata-shi, Niigata 950-2181 (JP); NEMOTO, Yuichi, Niigata-shi, Niigata 950-2181 (JP); Kaneta,Hiroshi, Niigata-shi, Niigata 9502181 (JP); Hourai Masatka, Tokyo 105-8634 (JP)
(74) Representative: Röthinger, Rainer
(86) International application number: PCT/JP2007/054619
(87) International publication number: WO 2007/100158

(56) References cited:
- EP-A1- 1 170 405
- EP-A1- 1 598 452
- EP-A2- 0 273 395
- JP-A- 01 098 960
- JP-A- 07 174 742

## Description

### TECHNICAL FIELD

This invention relates to a method for producing a Si single crystal ingot by CZ method, and more particularly to a method wherein Si single crystal ingots can be stably produced in accordance with various Si wafers required by consumers.

### RELATED ART

As a production method of Si single crystal ingot are known FZ method (floating zone method) and CZ method (Czochralski method). Among them, the CZ method is easy in the large-size formation and excellent in the productivity as compared with the FZ method, so that it is frequently used as a method for producing general-purpose wafers.

When the Si single crystal ingot is produced by the CZ method, the quality is dependent on a pulling rate. That is, in order to grow so-called non-defect crystal having substantially no Grow-in defect such as voids, dislocation cluster or the like formed due to the aggregation of point defect such as atomic vacancy, interstitial silicon or the like in an interior of Si crystal by the CZ method, the pulling rate V is strictly controlled so that the resulting Si crystal is grown into the non-defect crystal.

However, even if the pulling is carried out at a pulling rate V to be targeted, the desired non-defect crystal may not be obtained from various factors.

For instance, if there is a variation over time in a hot zone of the CZ apparatus, a temperature gradient G in the crystal changes, so that it is required to change a profile of a pulling rate V for achieving the target V/G.

Heretofore, a sample was cut out from a proper position of a Si crystal grown at a certain pulling rate profile, and then a type of a defect region was determined at this position. Also, in order to feed back the results to subsequent pulling treatment, a pattern of R-OSF (Ring-Oxidation induced Stacking Fault)/Pᵥ/Pᵢ, or a diameter of R-OSF or Pᵥ/Pᵢ boundary part was used as a control parameter for pulling. Here, all of Pᵥ and Pᵢ are included in a defect free region, wherein Pᵥ means a region having some atomic vacancy and Pᵢ means a region having some interstitial Si.

Further, the defect free region types Pᵥ and Pᵢ were determined by a Cu decoration method or from an oxygen precipitating distribution after a heat treatment. That is, the oxygen precipitation is promoted in the Pᵥ region because some atomic vacancy is existent, whereas the oxygen precipitation is suppressed in the Pᵢ region because some interstitial Si is existent, so that Pᵥ and Pᵢ defect regions are distinguished by observing through an X-ray topography or the like after the Cu decoration or the heat treatment for oxygen precipitation. Thus, these methods are basically a method of determining the type of Pᵥ, Pᵢ by the presence or absence of oxygen precipitating nucleus.

Therefore, when Si crystal is a high-oxygen crystal or a low-oxygen crystal, it is difficult to distinguish both the regions. Namely, in case of the high-oxygen crystal, the oxygen precipitation may be caused in either Pᵥ and Pᵢ regions, while in case of the low-oxygen crystal, the oxygen precipitation may not be caused in either Pᵥ and Pᵢ regions.

Moreover, even in an oxygen concentration range capable of distinguishing both the regions, a complicated heat treatment is required, which takes significant time and cost, so that there is a problem that the result can not be rapidly fed back to the subsequent pulling treatment.

In EP 1 170 405 A1 a method of producing nitrogen-doped Si single crystals by using the Czochralski growth technique is disclosed. Although the nitrogen doping supports the growth of defect-free crystals, the formation of OSFs is enhanced at the same time. In order to avoid the formation of OSF nuclei the oxygen concentration of the grown Si single crystal is controlled to be less than 8 ppma and the pulling rate V is appropriately adjusted to the nitrogen content.

EP 1 598 452 A1 discloses a method of growing Si single crystals using the Czochralski growth technique, wherein inert gas including hydrogen is used during the growth process in order to increase the pulling rate regime, at which defect-free crystals can be grown.

Lately, the inventors have developed a quantitative evaluation method of atomic vacancy, in which atomic vacancy in Si crystal is directly observed without depending on the oxygen concentration of the crystal and requiring the heat treatment and its existing concentration can be quantitatively evaluated, ahead of the world.

This method is a technique that the presence or absence of atomic vacancy in the Si crystal and the concentration thereof can be directly evaluated in a short time from a magnification of a reduction of elastic constant of Si crystal associated with cryogenic treatment (softening phenomenon) utilizing such a feature that an interaction between a triplet of electron orbital trapped in the atomic vacancy and a ultrasonic strain is very large.

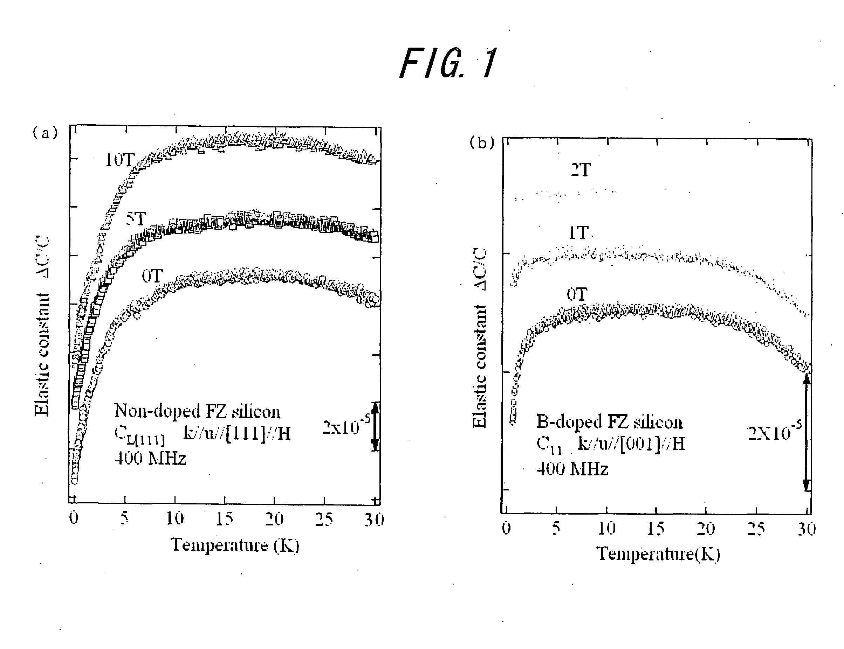

According to this method, as shown in FIGS. 1(a) and (b), when the atomic vacancy is existent in the Si crystal, the reduction of elastic constant (softening phenomenon) is caused with the cryogenic treatment, so that the concentration of atomic vacancy can be grasped by the degree of the reduction. Also, the kind of the Si crystal can be discriminated by the presence or absence of magnetic field dependence, because the atomic vacancy of Si crystal doped with am impurity takes on the magnetic field and if a strong magnetic field is applied, the softening phenomenon of the elastic constant is solved by the influence of the magnetic field, while the atomic vacancy of Si crystal not doped with an impurity does not take on the magnetic field and even if a strong magnetic field is applied, the softening tendency of elastic constant is unchanged.

The quantitative evaluation method of atomic vacancy is concretely described as follows.

That is, this is a method of quantitatively evaluating atomic vacancy existing in a silicon wafer which comprises oscillating a ultrasonic pulse onto a silicon sample cut out from a given site of a silicon wafer and directly provided on its surface with a thin-film transducer having properties capable of following to expansion associated with a temperature drop of the silicon sample at a temperature region of not higher than 25 K at a state of applying an exterior magnetic field, if necessary, while cooling at the above temperature region; propagating the oscillated ultrasonic pulse into the silicon sample; detecting a change of sonic velocity in the propagated ultrasonic pulse; calculating a reducing quantity of elastic constant associated with the drop of the cooling temperature from the change of sonic velocity; and quantitatively evaluating a kind and a concentration of atomic vacancy existing in the silicon wafer from the calculated reducing quantity of elastic constant.

### DISCLOSURE OF THE INVENTION

### PROBLEMS TO BE SOLVED BY THE INVENTION

It is an object of the invention to propose an advantageous production method of Si single crystal ingot by CZ method wherein a type of a defect region or a defect free region of Si single crystal grown at a certain pulling rate profile is clearly detected by utilizing a direct observation method of atomic vacancy in the above Si crystal and the resulting data are fed back to subsequent pulling, whereby Si single crystal having no defect region can be grown stably and further types Pᵥ, Pi of defect free region can be produced dividedly.

### MEANS FOR SOLVING PROBLEMS

That is, the summary and construction of the invention are as follows.
(1) A method for producing a Si single crystal ingot by a CZ method, which comprises detecting a concentration distribution of atomic vacancy in a radial direction of wafers cut out from plural crystal positions of a Si single crystal ingot grown by a precedent pulling treatment; and feeding back the detecting results to a subsequent pulling treatment to adjust a pulling rate profile in the subsequent pulling, wherein the detecting of the atomic vacancy in a silicon wafer comprises: oscillating an ultrasonic pulse onto each of wafer sample cut out from a given site of the silicon wafer and provided on its surface with a thin-film transducer, calculating a reduction quantity of elastic constant associated with a drop of the temperature of the wafer sample at a temperature region of not higher than 25K, from a change in sonic velocity of the ultrasonic pulse propagated through the wafer sample, and quantitatively evaluating a type and a concentration of atomic vacancy existing in the wafer sample from the calculated reduction quantity of elastic constant.
(2) A method of producing a Si single crystal ingot by a CZ method, according to item 1, further comprising determining a boundary between Pᵥ type defect free region and Pᵢ type defect free region in an as-grown state just after the growth of the crystal, and feeding back the results to a subsequent pulling treatment to adjust a pulling rate profile in the subsequent pulling.
(3) A method of producing a Si single crystal ingot by a CZ method according to item (1) or (2), wherein Si single crystal made of only Pᵥ type defect free region is grown by the adjustment of the pulling rate profile.
(4) A method for producing a Si single crystal ingot by a CZ method according to item (1) or (2), wherein Si single crystal made of only Pᵢ type defect free region is grown by the adjustment of the pulling rate profile.
(5) A method for producing a Si single crystal ingot by a CZ method according to item (1) or (2), wherein Si single crystal made of Pᵥ type defect free region and Pᵢ type defect free region is grown by the adjustment of the pulling rate profile.
(6) A method for producing a Si single crystal ingot by a CZ method according to item (1) or (2), wherein Si single crystal made of R-OSF region and Pᵥ type defect free region is grown by the adjustment of the pulling rate profile.

### EFFECT OF THE INVENTION

According to the invention, the pulling rate profile in the subsequent pulling can be controlled accurately so as to render into a defect free region by rapidly grasping the type of Si single crystal grown at the precedent pulling rate profile and feeding back it.

Further, according to the invention, types Pᵥ, Pᵢ of the defect free region can be discriminated, so that Si single crystal of Pᵥ alone or Pᵢ alone, which has been said to be very difficult, can be produced stably.

### BRIEF DESCRIPTION OF THE DRAWINGS

FIG. 1 is a graph showing a softening tendency of elastic constant at a cryogenic temperature zone of (a) Si crystal not doped with an impurity and (b) Si crystal doped with an impurity using a magnification of a magnetic field applied as a parameter.
FIG. 2 is (a) a view showing a distribution of defects states at a longitudinal section of a typical Si crystal ingot and (b) a graph showing a comparison of softening tendency at cryogenic temperature zones of samples taken from Pᵥ, Pᵢ regions.
FIG. 3 is a view showing a typical product pattern of Si wafer.
FIG. 4 is (a) a view showing a distribution of defect states at a longitudinal section of Si crystal ingot and (b) a view showing a concentration distribution [V](c) of atomic vacancy at a cross-sectional center position of Si wafer obtained by pulling at each of pulling velocities A-F.
FIG. 5 is a view showing a concentration distribution [V](c) in a 15 radial direction of Si wafer obtained by pulling at each of pulling velocities A-F.
FIG. 6 is a view illustrating a procedure for measuring a concentration distribution of atomic vacancy in a radial direction of Si wafer.

### BEST MODE FOR CARRYING OUT THE INVENTION

The invention will be concretely described below.

As previously mentioned, the presence or absence of atomic vacancy in Si crystal can be discriminated by using the direct observation method of atomic vacancy in Si crystal developed before the invention to measure the reduction of elastic constant (softening phenomenon) at the cryogenic temperature treatment.

That is, as atomic vacancies are existent in the Si crystal, the softening of elastic constant is caused with cryogenic temperature treatment. If Pᵥ type defect free region is existent, therefore, the softening of elastic constant is caused at the cryogenic temperature.

On the other hand, Pi type is at a state of penetrating Si atom between 30 lattices and atomic vacancy is not existent therein, so that the softening of elastic constant is not caused even at the cryogenic temperature.

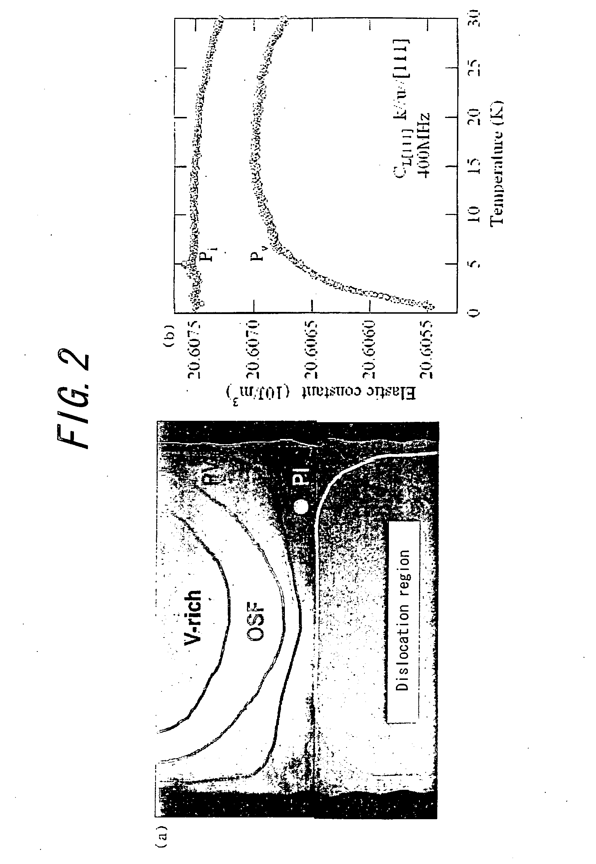

In FIG. 2(a) is shown a distribution of defect states at a longitudinal section of a typical Si crystal ingot, and FIG. 2(b) shows results examined on a softening tendency of samples taken from Pᵥ, Pᵢ regions at a cryogenic temperature zone using a direct observation method of atomic vacancy according to the invention.

As seen from this figure (b), in case of the Pᵥ type, the remarkable softening of elastic constant is caused at the cryogenic temperature zone, while in case of the Pᵢ type, the softening of elastic constant is not caused even at the cryogenic temperature zone.

Therefore, the Pᵥ type and the Pᵢ type can be discriminated clearly by utilizing the above direct observation method.

Also, the boundary between Pv region and Pi region can be determined clearly. Although the definition of Pv/Pi boundary without being subjected to a treatment such as complicated heat treatment, Cu decoration or the like is very difficult in the conventional technique, it can be determined simply and rapidly at an as-grown state just after the growth by utilizing the direct observation method according to the invention.

Then, the production method of different crystal types according to the invention will be described.

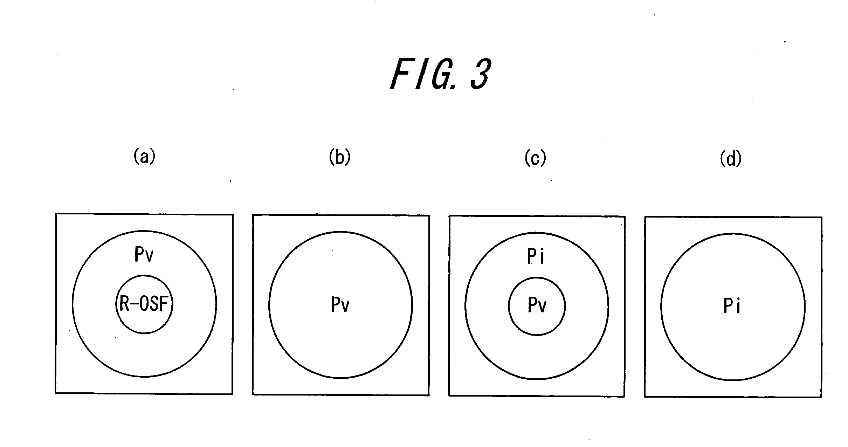

As a typical product pattern of Si wafer in the consumers are considered four types shown in FIGS. 3(a)-(d).

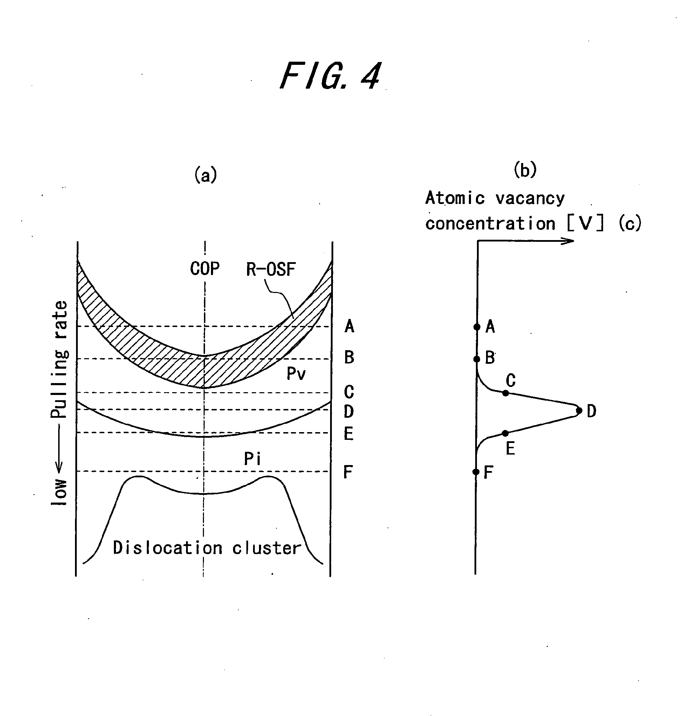

In order to produce these products, it is required to adjust the pulling rate in accordance with the product pattern, which is explained using FIG. 4.

FIG. 4(a) is a view of a distribution of defect states at the longitudinal section of the same Si crystal ingot as previously mentioned, and FIG. 4(b) shows a concentration distribution [V] (arbitrary unit) of atomic vacancy at cross-sectional center position of Si wafer obtained by pulling at each of pulling velocities A-F shown in FIG. 4(a).

In FIG. 4(a), since the pulling rate for obtaining the Pᵥ region is between "velocity C" and "velocity D", the concentration distribution of atomic vacancy at the cross-sectional center position is as shown in FIG. 4(b). Moreover, the concentration of atomic vacancy is highest in the central portion of the Pᵥ region and gradually lowers as separated away from the central portion and becomes zero at a point of arriving at R-OSF/Pᵥ boundary or Pᵥ/Pᵢ boundary.

In this way, the distribution corresponding to the concentration of atomic vacancy is obtained in the Pv region, which can be utilized to produce products of various patterns dividedly.

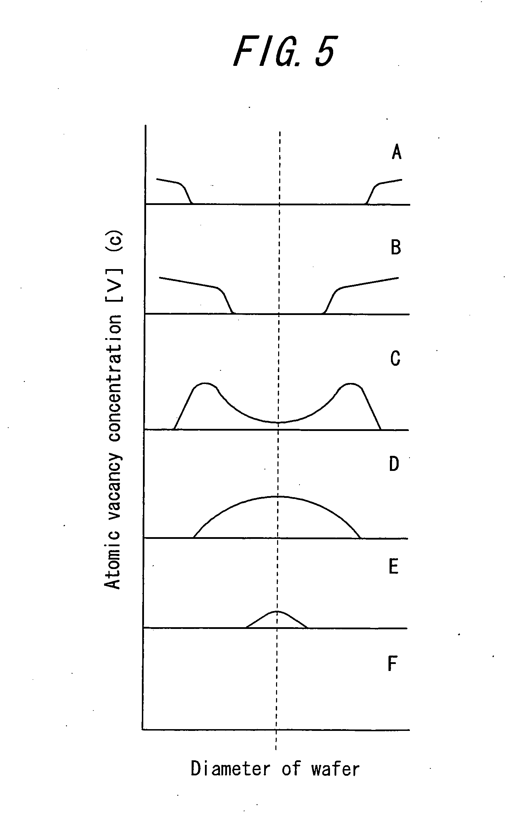

In FIG. 5 is shown a concentration distribution [V] (arbitrary unit) of atomic vacancy in a radial direction of the Si wafer obtained by pulling at each of pulling velocities A-F shown in FIG. 4(a).

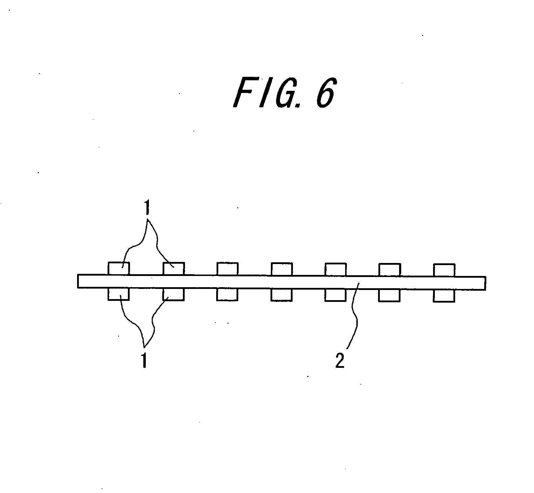

Moreover, the concentration distribution of atomic vacancy in the radial direction of the Si wafer can be measured by disposing a plurality of probes (voltage films) 1 for the direct observation method on a Si wafer 2 as a sample in a diameter direction thereof as shown in FIG. 6. Here, the voltage film (which is also called a thin-film transducer) 1 may be a film being very rich in the adhesion property by directly depositing ZnO or AlN on the surface of the sample. In the formation of the voltage film 1, C-axis thereof is grown somewhat obliquely with respect to the sample surface and lateral component of ultrasonic wave is measured, whereby the resolution can be more improved.

When the pulling is conducted at a "velocity A" in FIG. 4(a), the Pᵥ region is existent in only an outer periphery of the resulting Si wafer, so that as shown in "A" of FIG. 5, the result measured on the atomic vacancy concentration by the direct observation method shows that the atomic vacancy concentration becomes high at only the outer peripheral portion of the Si wafer.

Similarly, when the pulling is conducted at a "velocity B" in FIG. 4(a), the Pᵥ region is existent in the resulting Si wafer from an inner side as compared with the case of "velocity A", so that the atomic vacancy concentration becomes a distribution as shown in "B" of FIG. 5.

Also, when the pulling is conducted at a "velocity C" in FIG. 4(a), substantially a whole region of an interior of the resulting Si wafer is the Pᵥ region, so that the atomic vacancy concentration becomes a distribution as shown in "C" of FIG. 5. Moreover, a region wherein the atomic vacancy concentration of an outermost peripheral portion of the Si wafer is zero can be estimated to be Pᵢ.

Similarly, when the pulling is conducted at a "velocity D" in FIG. 4(a), a central region of the resulting Si wafer is the Pᵥ region, so that the atomic vacancy concentration becomes a distribution as shown in "D" of FIG. 5. Even in this case, a region wherein the atomic vacancy concentration of an outermost peripheral portion of the Si wafer is zero can be estimated to be Pᵢ.

Furthermore, when the pulling is conducted at a "velocity E" in FIG. 4(a), only an interior of the resulting Si wafer is the Pᵥ region, so that the atomic vacancy concentration becomes a distribution as shown in "E" of FIG. 5. Even in this case, a region wherein the atomic vacancy concentration of an outermost peripheral portion of the Si wafer is zero can be estimated to be Pᵢ.

Similarly, when the pulling is conducted at a "velocity F" in FIG. 4(a), a whole region of the resulting Si wafer is the Pᵢ region, so that the atomic vacancy concentration over the whole region becomes zero as shown in "F" of FIG. 5.

Therefore, if the distribution of atomic vacancy concentration as shown in "B" of FIG. 5 is inversely obtained, it can be estimated that the interior of the Si wafer is R-OSF region and the outer peripheral portion thereof is the P_{V} region.

This corresponds to a product pattern shown in FIG. 3(a).

Also, if the distribution of atomic vacancy concentration as shown in "C" of FIG. 5 is obtained, it can be estimated that a greater part of the Si wafer is the P_{V} region. This corresponds to a product pattern shown in FIG. 3(b).

Further, if the distribution of atomic vacancy concentration as shown in "D" or "E" of FIG. 5 is obtained, it can be estimated that the interior of the Si wafer is the Pᵥ region and the outer peripheral portion thereof is the Pᵢ region. This corresponds to a product pattern shown in FIG. 3(c).

In addition, if the distribution of atomic vacancy concentration as shown in "F" of FIG. 5 is obtained, it can be estimated that the whole region of the Si wafer is the Pᵢ region. This corresponds to a product pattern shown in FIG. 3(d).

### EXAMPLES

### Example 1

A Si single crystal ingot having a diameter of 200 mm is produced by using CZ method under the following conditions.

Into a quartz crucible of 24 inches in diameter is charged 120 kg of a high purity polysilicon starting material, which is placed in a CZ crystal growing apparatus to conduct the growth of silicon single crystal having a target diameter: 210 mm and a body length: 1000 mm.

In the CZ crystal growing apparatus, a heat shielding body of an inverted conical trapezoid for shielding radiation heat from a silicon molten liquid in the quartz crucible and a cylindrical graphite heater surrounding the quartz crucible is disposed at an upper part of the silicon molten liquid so as to surround a pulled crystal. The heat shielding body is an inverted conical trapezoidal body of graphite having a structure filled in its interior with a graphite felt and an inner diameter of an upper end of 480 mm, an inner diameter of a lower end of 270 mm, a thickness of 30 mm and a height of 500 mm.

Also, the heat shielding body is disposed so that a gap between the lower end of the body and the surface of the molten liquid is 60 mm. When the quartz crucible, silicon molten liquid, graphite heater and heat shielding body are arranged as mentioned above, the radial distribution of temperature gradient of the crystal in the pulling axial direction in the vicinity of the crystal interface to the molten liquid is made substantially uniform, so that it is possible to attain the growth of non-defect crystal having a defect distribution as shown in FIGS. 3(a), (b), (c) and (d).

The interior of the apparatus is rendered into an argon atmosphere under a reduced pressure, and heated by the graphite heater to form a silicon molten liquid. A seed crystal attached to a seed chuck is immersed in the molten liquid and then pulled therefrom while rotating the crucible and the pulling axis of the chuck.

After the seed squeezing for no dislocation of crystal at a crystal orientation of {100}, a shoulder portion is formed and changed for obtaining a target body diameter.

At a time that a body length arrives at 100 mm, the pulling rate is adjusted to 0.5 mm/min and subsequently lowered substantially linearly in accordance with the pulling length. At a time that the body length arrives at 900 mm, the pulling rate is made to 0.4 mm/min and then the growth is continued to 1000 mm at this pulling rate , and thereafter a tail squeezing is conducted to terminate the pulling.

Wafers are cut out from the resulting Si single crystal ingot in a radial direction at positions corresponding to body lengths of 300 mm (pulling rate : about 0.475 mm/min), 500 mm (pulling rate : about 0.45 mm/min) and 700 mm (pulling rate : about 0.425 mm/min), respectively.

These wafers are subjected to an etching treatment of about 0.5 mm with a mixed solution of nitric acid and hydrofluoric acid to remove damages due to the work to thereby form mirrored wafers having a thickness of about 3 mm.

With respect to the resulting wafers, an atomic vacancy concentration distribution in a radial direction is investigated by a quantitative evaluation method of atomic vacancy. Moreover, the preparation of the wafer after the crystal pulling and the investigation for the quantitative evaluation of atomic vacancy could be carried out in a short time of about 12 hours.

As a result, there is obtained a product pattern as shown in FIG. 3(c), i.e. a product pattern wherein an interior of the wafer is a Pᵥ region and an outer peripheral portion thereof is a Pᵢ region.

Now, the production conditions of the ingot are changed so as to render the subsequent Si ingot into a product pattern as shown in FIG. 3(b).

Using the same CZ crystal growing apparatus as mentioned above, the pulling rate is adjusted to 0.55 mm/min at a time that a body length arrives at 100 mm and subsequently lowered substantially linearly in accordance with the pulling length. At a time that the body length arrives at 900 mm, the pulling rate is made to 0.45 mm/min and then the growth is continued to 1000 mm at this pulling rate , and thereafter a tail squeezing is conducted to terminate the pulling.

Wafers are cut out from the resulting Si single crystal ingot in a radial direction at positions corresponding to body lengths of 300 mm (pulling rate : about 0.525 mm/min), 500 mm (pulling rate : about 0.5 mm/min) and 700 mm (pulling rate : about 0.475 mm/min), respectively, and the atomic vacancy concentration distribution in the radial direction is investigated by the same quantitative evaluation method of atomic vacancy, whereby the wafers are confirmed to be a targeted product pattern as shown in FIG. 3(b) in which a greater part of Si wafer is a Pᵥ region..

Further, the production conditions of the ingot are changed so as to render the subsequent Si ingot into a product pattern as shown in FIG. 3(d).

Using the same CZ crystal growing apparatus as mentioned above, the pulling rate is adjusted to 0.45 mm/min at a time that a body length arrives at 100 mm and subsequently lowered substantially linearly in accordance with the pulling length. At a time that the body length arrives at 900 mm, the pulling rate is made to 0.35 mm/min and then the growth is continued to 1000 mm at this pulling rate , and thereafter a tail squeezing is conducted to terminate the pulling.

Wafers are cut out from the resulting Si single crystal ingot in a radial direction at positions corresponding to body lengths of 300 mm (pulling rate : about 0.425 mm/min), 500 mm (pulling rate : about 0.4 mm/min) and 700 mm (pulling rate : about 0.375 mm/min), respectively, and the atomic vacancy concentration distribution in the radial direction is investigated by the same quantitative evaluation method of atomic vacancy, whereby the wafers are confirmed to be a targeted product pattern as shown in FIG. 3(d) in which a greater part of Si wafer is a Pᵢ region..

### INDUSTRIAL APPLICABILITY

As mentioned above, according to the invention, the defect free region type of Si single crystals grown can be rapidly discriminated by observing a distribution of atomic vacancy concentration in a sample through the direct observation method of atomic vacancy, and also products having various patterns in accordance with consumer's requirements can be produced dividedly by feeding back the obtained data to the subsequent pulling treatment.

## Claims

1. A method of producing a Si single crystal ingot by a CZ method, comprising:
detecting a concentration distribution of atomic vacancy in a radial direction of wafers cut out from plural crystal positions of a Si single crystal ingot grown by a precedent pulling treatment; and
feeding back the detecting results to a subsequent pulling treatment to adjust a pulling rate profile in the subsequent pulling
wherein the detecting of the atomic vacancy in a silicon wafer comprises:
oscillating an ultrasonic pulse onto a wafer sample cut out from a given site of the silicon wafer and provided on its surface with a thin-film transducer;
calculating a reduction quantity of elastic constant associated with a drop of the temperature of the wafer sample at a temperature region of not higher than 25 K, from a change in sonic velocity of the ultrasonic pulse propagated through the wafer sample; and
quantitatively evaluating a type and a concentration of atomic vacancy existing in the wafer sample from the calculated reduction quantity of elastic constant.

2. A method of producing a Si single crystal ingot by a CZ method, according to claim 1, further comprising:
determining a boundary between Pᵥ type defect free region and Pᵢ type defect free region in an as-grown state just after the growth of the crystal; and
feeding back the results to a subsequent pulling treatment to adjust a pulling rate profile in the subsequent pulling.

3. A method of producing a Si single crystal ingot by a CZ method according to claim 1 or 2, wherein Si single crystal made of only Pᵥ type defect free region is grown by the adjustment of the pulling rate profile.

4. A method of producing a Si single crystal ingot by a CZ method according to claim 1 or 2, wherein Si single crystal made of only Pᵢ type defect free region is grown by the adjustment of the pulling rate profile.

5. A method of producing a Si single crystal ingot by a CZ method according to claim 1 or 2, wherein Si single crystal made of Pᵥ type defect free region and Pᵢ type defect free region is grown by the adjustment of the pulling rate profile.

6. A method of producing a Si single crystal ingot by a CZ method according to claim 1 or 2, wherein Si single crystal made of R-OSF region and Pᵥ type defect free region is grown by the adjustment of the pulling rate profile.

## Patentansprüche

1. Verfahren zur Herstellung eines Si-Einkristallblocks mittels eines CZ-Verfahrens, umfassend:
Ermitteln einer Konzentrationsverteilung atomarer Leerstellen in einer radialen Richtung von Wafern, die aus verschiedenen Kristallpositionen von einem Si-Einkristallblock herausgeschnitten wurden, der mittels einer vorhergehenden Ziehbehandlung gewachsen wurde; und
Berücksichtigen der Ermittlungsergebnisse bei einer nachfolgenden Ziehbehandlung, um ein Ziehratenprofil bei dem nachfolgenden Ziehen einzustellen,
wobei das Ermitteln der atomaren Leerstellen in einem Silizium-Wafer umfasst:
Oszillieren eines Ultraschall-Pulses auf eine Waferprobe, die von einer gegebenen Stelle des Silizium-Wafers ausgeschnitten wurde und auf ihrer Oberfläche mit einem Dünnfilm-Transducer versehen wurde;
Berechnen einer Verringerungsgröße einer elastischen Konstante, die mit einem Temperaturabfall der Waferprobe in einem Temperaturbereich von nicht über 25 K einhergeht, auf der Grundlage einer Änderung der Schallgeschwindigkeit des durch die Waferprobe propagierten Ultraschall-Pulses; und
quantitative Beurteilung eines Typs und einer Konzentration von in der Waferprobe existierenden atomaren Leerstellen auf der Grundlage der berechneten Verringerungsgröße der elastischen Konstante.

2. Verfahren zum Herstellen eines Si-Einkristallblocks durch ein CZ-Verfahren nach Anspruch 1, ferner umfassend:
Bestimmen einer Grenze zwischen einer Pᵥ-Typ defektfreien Region und einer Pᵢ-Typ defektfreien Region in einem "wie-gewachsen"-Zustand unmittelbar nach dem Wachsen des Kristalls; und
Berücksichtigen der Ergebnisse bei einer nachfolgenden Ziehbehandlung, um ein Ziehratenprofil bei dem nachfolgenden Ziehen einzustellen.

3. Verfahren zum Herstellen eines Si-Einkristallblocks durch ein CZ-Verfahren gemäß Anspruch 1 oder 2, wobei der Si-Einkristall, der ausschließlich aus einem Pᵥ-Typ defektfreien Bereich besteht, durch Einstellen des Ziehratenprofils gewachsen wird.

4. Verfahren zum Herstellen eines Si-Einkristallblocks durch ein CZ-Verfahren gemäß Anspruch 1 oder 2, wobei der Si-Einkristall, der ausschließlich aus einem Pᵢ-Typ defektfreien Bereich besteht, durch Einstellen des Ziehratenprofils gewachsen wird.

5. Verfahren zum Herstellen eines Si-Einkristallblocks durch ein CZ-Verfahren gemäß Anspruch 1 oder 2, wobei der Si-Einkristall, der aus einem Pᵥ-Typ defektfreien Bereich und einem Pᵢ-Typ defektfreien Bereich besteht, durch Einstellen des Ziehratenprofils gewachsen wird.

6. Verfahren zum Herstellen eines Si-Einkristallblocks durch ein CZ-Verfahren gemäß Anspruch 1 oder 2, wobei der Si-Einkristall, der aus einem R-OSF-Bereich und einem Pᵥ-Typ defektfreien Bereich besteht, durch Einstellen des Ziehratenprofils gewachsen wird.

## Revendications

1. Procédé de production d'un lingot monocristallin de Si par un procédé CZ, comprenant :
la détection d'une distribution de concentration de lacune atomique dans un sens radial de tranches découpées à partir de positions cristallines multiples d'un lingot monocristallin de Si fait croître par un traitement de tirage précédent ; et
le renvoi des résultats de détection à un traitement de tirage suivant pour ajuster un profil de vitesse de tirage lors du tirage suivant,
dans lequel la détection de la lacune atomique dans une tranche de silicium comprend :
l'oscillation d'une impulsion ultrasonore sur un échantillon de tranche découpé à partir d'un site donné de la tranche de silicium et doté sur sa surface d'un transducteur en couche mince ;
le calcul d'une quantité de réduction de constante élastique associée avec une chute de la température de l'échantillon de tranche dans une région de température non supérieure à 25 K, à partir d'un changement de vitesse sonique de l'impulsion ultrasonore propagée à travers l'échantillon de tranche ; et
l'évaluation quantitative d'un type et d'une concentration de lacune atomique existant dans l'échantillon de tranche à partir de la quantité calculée de réduction de constante élastique.

2. Procédé de production d'un lingot monocristallin de Si par un procédé CZ selon la revendication 1, comprenant en outre :
la détermination d'une limite entre une région dépourvue de défauts de type Pᵥ et une région dépourvue de défauts de type Pᵢ dans un état tel que crû juste après la croissance du cristal ; et
le renvoi des résultats à un traitement de tirage suivant pour ajuster un profil de vitesse de tirage lors du tirage suivant.

3. Procédé de production d'un lingot monocristallin de Si par un procédé CZ selon la revendication 1 ou 2, dans lequel un monocristal de Si constitué uniquement d'une région dépourvue de défauts de type Pᵥ est fait croître par l'ajustement du profil de vitesse de tirage.

4. Procédé de production d'un lingot monocristallin de Si par un procédé CZ selon la revendication 1 ou 2, dans lequel un monocristal de Si constitué uniquement d'une région dépourvue de défauts de type Pᵢ est fait croître par l'ajustement du profil de vitesse de tirage.

5. Procédé de production d'un lingot monocristallin de Si par un procédé CZ selon la revendication 1 ou 2, dans lequel un monocristal de Si constitué d'une région dépourvue de défauts de type Pᵥ et d'une région dépourvue de défauts de type Pᵢ est fait croître par l'ajustement du profil de vitesse de tirage.

6. Procédé de production d'un lingot monocristallin de Si par un procédé CZ selon la revendication 1 ou 2, dans lequel un monocristal de Si constitué d'une région R-OSF et d'une région dépourvue de défauts de type Pᵥ est fait croître par l'ajustement du profil de vitesse de tirage.
